# EUROPEAN PATENT APPLICATION

(11) **EP 1 691 420 A1**
(43) Date of publication of application: **16.08.2006**
(21) Application number: 06001888.4
(22) Date of filing: 30.01.2006
(51) Int. Cl.: H01L 29/872, H01L 27/08

(54) **Schottky diode and fabrication method therefor**

(30) Priority: 15.02.2005 KR 2005012431
(71) Applicant: Samsung Electronics Co., Ltd., Suwon-si, Gyeonggi-Do (KR)
(72) Inventor: Shim, Dong-sik, Suwon-si Gyeonggi-do (KR); Ku, Ja-nam, Yongin-si Gyeonggi-do (KR); Min, Young-hoon, Dongan-gu Anyang-si Gyeonggi-do (KR); Song, Il-jong, Jangan-gu Suwon-si Gyeonggi-do (KR); Choi, Hyung, Bundang-gu Seongnam-si Gyeonggi-do (KR)
(74) Representative: Grünecker, Kinkeldey, Stockmair & Schwanhäusser Anwaltssozietät

(57) **Abstract**

A semiconductor device using schottky diodes for removing noise, a fabrication method, and an electrostatic discharge prevention device are provided. The semiconductor device includes a P-well substrate; insulation layers deposited on etched regions of the substrate; an N-well layer deposited on an etched region of the P-well substrate between the insulation layers; P⁺ type implants injected to a first region and a second region of the N-well layer; and first and second metals formed in schottky contact on the first and second regions, respectively. The method includes etching away regions of a P-well substrate and depositing an insulation substance; etching away the P-well substrate and depositing the insulation substance between the insulation layers to create an N-well layer; injecting P⁺ type implants to a first region and a second region of the N-well layer; and forming first and second metals in schottky contact on the first and second regions, respectively.

## Description

### BACKGROUND OF THE INVENTION

### 1. Field of the Invention

Apparatuses and methods consistent with the present invention relate to a schottky diode-based noise-removing semiconductor device and a fabrication method therefor, and more particularly to a schottky diode-based noise-removing semiconductor device with the same electrodes of schottky diodes connected to each other and a fabrication method therefor capable of rectifying analog and digital signals flowing to the semiconductor device.

### 2. Description of the Related Art:

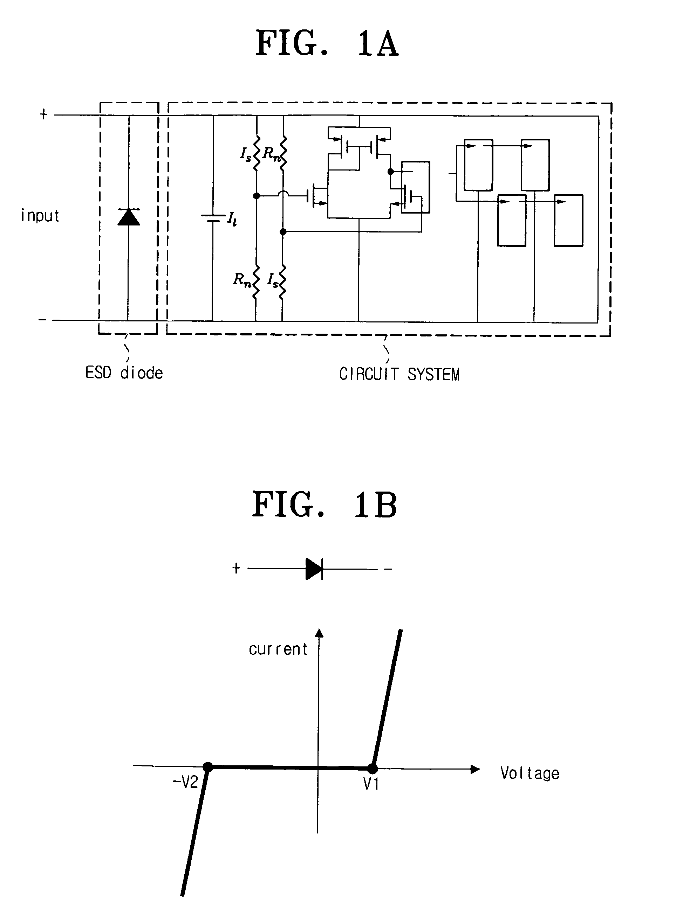

FIG 1A and FIG 1B are views showing the operation of an electrostatic discharge (ESD) device using a general schottky diode.

FIG 1A is a view showing an ESD diode disposed at the stage prior to a circuit system, and FIG 1B is a view showing voltage-to-current characteristics of the schottky diode shown in FIG 1A. Here, the ESD device refers to a device passing only signals necessary for semiconductor protections while removing only unnecessary signals since some semiconductors are fragile to static electricity.

In FIG 1A and FIG 1B, the electric currents flowing in the schottky diode are expressed as an exponential function of voltages applied thereto, and the currents can be controlled in the schottky barriers. The schottky diode exponentially increases currents with respect to voltages applied thereto if the voltages are higher than a certain voltage V1. Further, if the schottky diode is reverse-biased with a voltage higher than a certain voltage V2, breakdown currents flow in the schottky diode due to the breakdown phenomena in the schottky diode. Here, the voltage V2 is higher than the voltage V1.

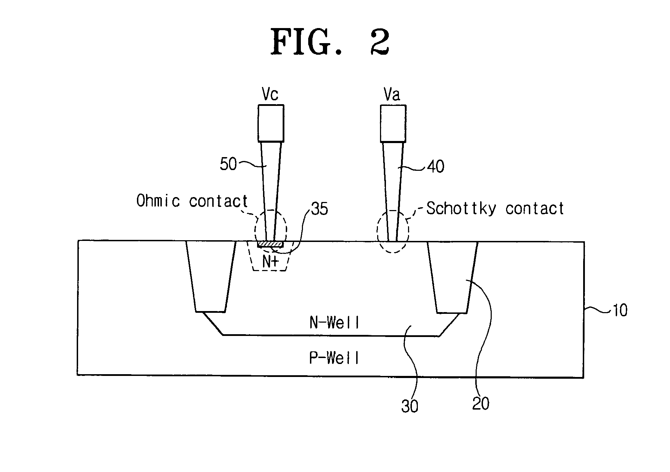

FIG 2 is a view showing a conventional schottky diode.

In FIG 2, the conventional schottky diode has a substrate 10, insulation layers 20, an N-well layer 30, a first metal 40, and a second metal 50. The substrate 10 is a P-well substrate, and the insulation layers 20 are formed in regions of the substrate 10. The N-well layer 30 is formed between the insulation layers 20, and the first and second metals 40 and 50 are formed on top of the N-well layer 30. Here, the first metal 40 is formed, as a positive electrode, in the schottky contact with the N-well layer 30. However, the second metal 50 is formed, as a negative electrode, on top of a n⁺ type implant 35 of the N-well layer 30, and is in the ohmic contact with the N-well layer 30.

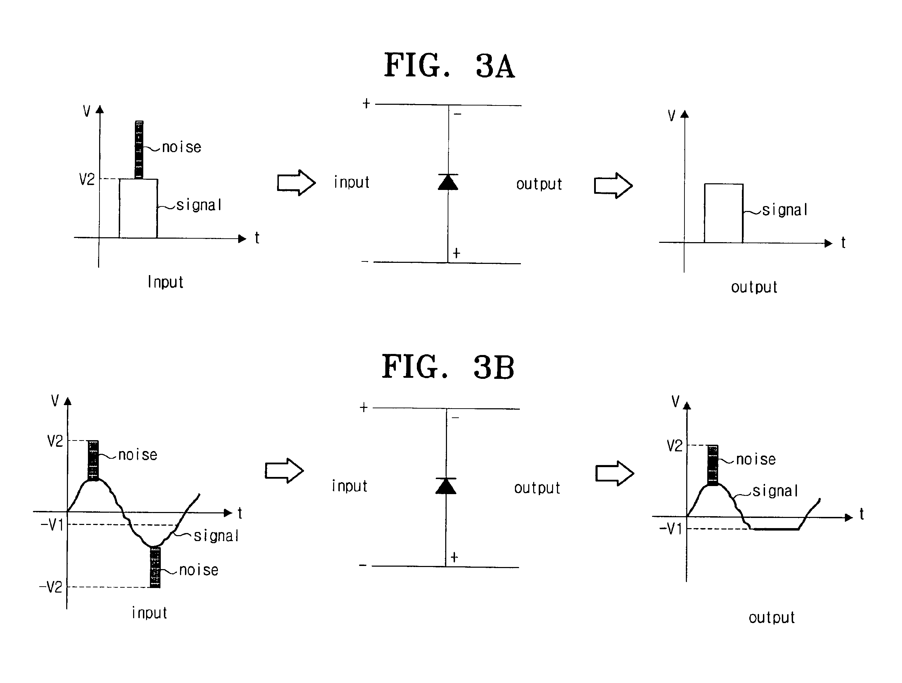

FIG 3A and FIG 3B are views explaining the noise removal operations of the conventional schottky diode. FIG 3A is a view explaining that the schottky diode serves as an ESD device and removes noise when an input signal is a noise-bearing digital signal. Further, FIG 3B is a view explaining that the schottky diode serves as an ESD device and removes noise when an input signal is a noise-bearing analog signal.

In FIG 3A and FIG 1B, if a noise-bearing digital signal is input to the schottky diode, the magnitude of the breakdown voltage of the schottky diode is adjusted so that the noise can be removed. If the voltage of a noise signal is a voltage V2, the schottky diode is short-circuited to the ground if the voltage is over the voltage V2. Thus, the noise signal over the voltage V2 is not input to a circuit system connected to the schottky diode, so the noise is removed.

In FIG 3B and FIG 1B, if a noise-bearing analog signal is input to the schottky diode, the schottky diode is open-circuited when the signal is below the voltage V2, so the signal below the voltage V2 is inputted to the circuit system connected to the schottky diode.

However, if the voltage of an input analog signal is a negative voltage of -V1, the signal over the voltage of |-V1| is not input to the circuit system connected to the schottky diode since currents flow to the ground due to the short-circuit of the schottky diode. That is, for an input analog signal shown in FIG 3B, there exists a problem of leakage of an input signal in addition to a noise signal since a signal between voltages of -V1 and -V2 is not input to the circuit system connected to the schottky diode. Therefore, the conventional schottky diode used as an EDS device has a problem that it cannot deal with noise caused by an analog signal.

### SUMMARY OF THE INVENTION

The present invention addresses the above drawbacks and other problems associated with the conventional arrangement. An aspect of the present invention is to provide a semiconductor device using schottky diodes of which the same electrodes are connected to each other and which is capable of rectifying digital signals and analog signals, and a fabrication method therefor, in order to remove noise.

According to an exemplary embodiment of the present invention, a semiconductor device fabrication method is provided. The method includes forming insulation layers by etching away regions of a P-well substrate in a certain interval and depositing an insulation substance; depositing an N-well layer by etching away the P-well substrate and depositing an insulation substance between the insulation layers; injecting P⁺ type implants to a first region and a second region of the N-well layer; and deposting first and second metals in schottky contact on the first and second regions, respectively.

The P⁺ type implants may be deposited injecting the P⁺ type implants to both sides of the region at which the first metal is disposed and to both sides of the region at which the second metal is disposed, and by heat-treating, thereby preventing leakage currents from flowing to the first and second metals.

According to another exemplary embodiment of the present invention, a semiconductor device using schottky diodes to remove noise is provided. The device includes a P-well substrate; insulation layers deposited on etched regions of the P-well substrate and formed in a certain interval; an N-well layer deposited on the etched region of the P-well substrate between the insulation layers; P⁺ type implants injected to a first region and a second region of the N-well layer; and first and second metals formed in schottky contact on the first and second regions, respectively.

According to another exemplary embodiment of the present invention, the semiconductor device is used as an electrostatic discharge (ESD) device, and prevents static electricity from flowing to a circuit system connected to the semiconductor device.

### BRIEF DESCRIPTION OF THE DRAWINGS

The above and other aspects of the present invention will be more apparent by describing certain exemplary embodiments of the present invention with reference to the accompanying drawings, in which:

FIG 1A and FIG 1B are views explaining the operation of an ESD device using general schottky diodes;

FIG 2 is a view showing a conventional schottky diode;

FIG 3A and FIG 3B are views explaining the noise removal operations of the conventional schottky diode;

FIG 4 is a view for showing a semiconductor device for removing noise by using schottky diodes according to an exemplary embodiment of the present invention;

FIG 5 is a view for showing characteristics of a semiconductor device for removing noise by using schottky diodes according to an exemplary embodiment of the present invention;

FIG 6A to FIG 6E are views explaining a method for fabricating a semiconductor device for removing noise by using schottky diodes according to an exemplary embodiment of the present invention;

FIG 7 is a view explaining noise removal operations by the semiconductor device of FIG 4; and

FIG 8 is a flow chart explaining a method for fabricating a semiconductor device .for removing noise by using schottky diodes according to an exemplary embodiment of the present invention.

### DETAILED DESCRIPTION OF THE EXEMPLARY EMBODIMENTS OF THE PRESENT INVENTION

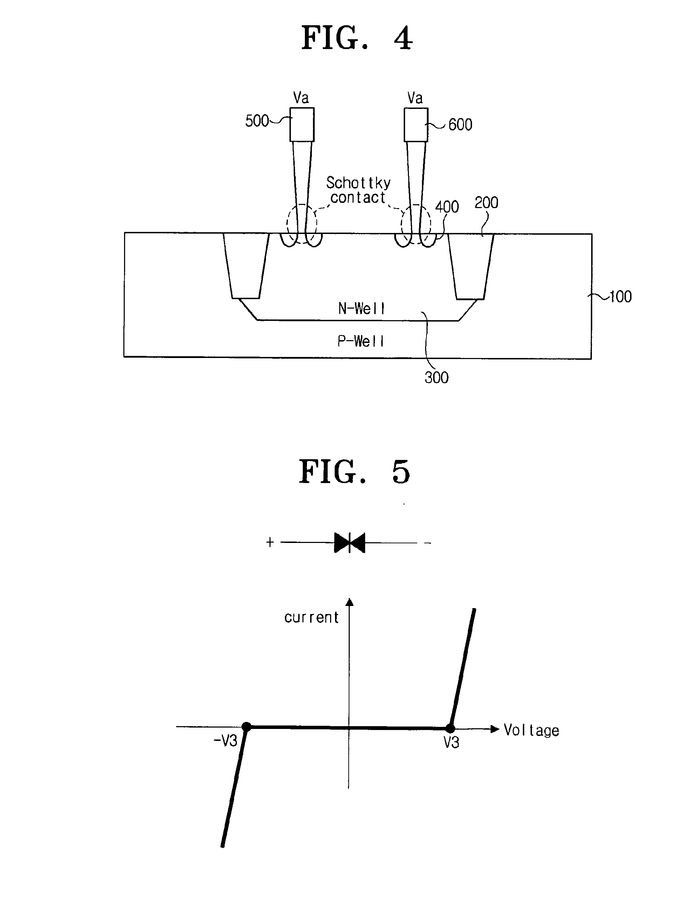

FIG 4 is a view for showing a semiconductor device for removing noise by using schottky diodes according to an exemplary embodiment of the present invention.

In FIG 4, the semiconductor device for removing noise by using schottky diodes according to an exemplary embodiment of the present invention is provided with a substrate 100, insulation layers 200, an N-well layer 300, P⁺ type implants 400, a first metal 500, and a second metal 600.

The substrate 100 is a P-well substrate, and the insulation layers 200 are formed in an interval on regions of the substrate 100. The N-well layer 300 is formed between the insulation layers 200 formed in the interval. Further, the first and second metals 500 and 600 are formed on the N-well layer 300. P⁺ type implants are injected in the lower portions where the first and second metals 500 and 600 are formed, so as to prevent leakage currents from flowing to the first and second metals 500 and 600. Here, the first and second metals 500 and 600 are positive electrodes.

FIG 5 is a view for showing characteristics of a semiconductor device for removing noise by using the schottky diodes according to an exemplary embodiment of the present invention.

FIG 5 shows voltages-to-currents relations of the schottky diode of FIG 4, in which the schottky diode is open-circuited if a voltage between a voltage of -V3 and a voltage of +V3 is applied to the schottky diode, so a signal input to the schottky diode is output to a circuit system connected to the schottky diode. However, if a signal input to the schottky diode is higher than the voltage V3 or lower than the voltage -V3, the schottky diode is short-circuited, so the input signal is not output to the circuit system connected to the schottky diode. That is, the schottky diode of FIG 4 passes only a signal in a certain range, so as to serve as a device capable of removing noise.

The diode formed with two schottky diodes connected together according to an exemplary embodiment of the present invention has different voltages-to-currents characteristics from the conventional schottky diode since the schottky diode is short-circuited at voltages V3 and -V3, denoting that the positive and negative voltages have the same magnitude. Thus, if an analog signal having noise is input, the schottky diode can remove the noise without loss of the input signal.

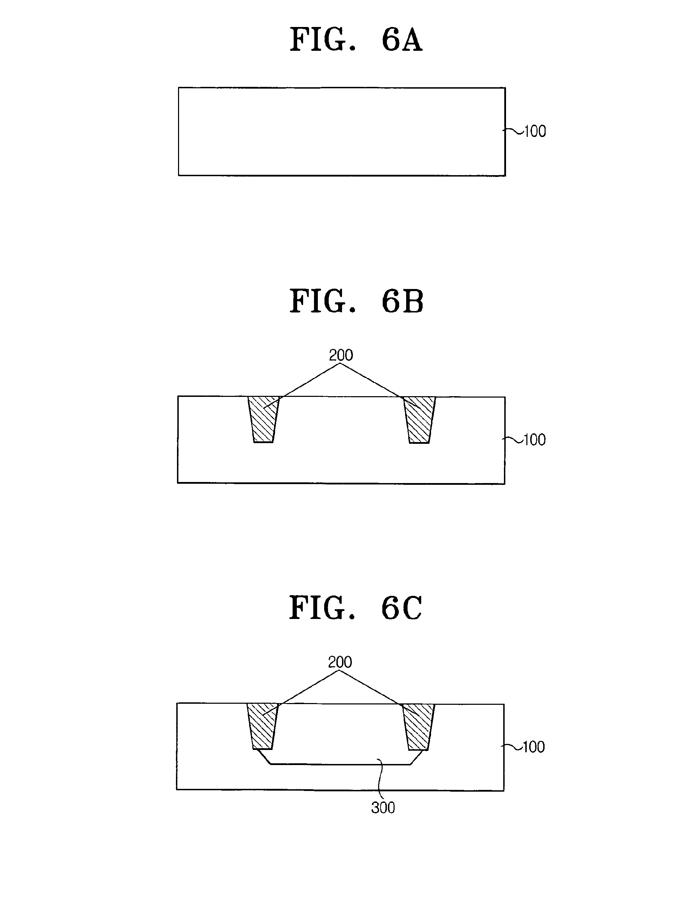

FIG 6A to FIG 6E are views explaining a method for fabricating a semiconductor device for removing noise by using schottky diodes according to an exemplary embodiment of the present invention.

In FIG 6A and FIG 6B, the insulation layers 200 are formed in an interval on regions of the P-type substrate 100. The insulation layers 200 are formed by etching away regions of the substrate 100 and forming a nitride oxide layer on the substrate 100.

In FIG 6C, the N-well layer 300 is formed by injecting a substance such as As or a material containing As, or other N-well creating materials known in the art, to the substrate 100 between the insulation layers 200 and heat-treating the substrate.

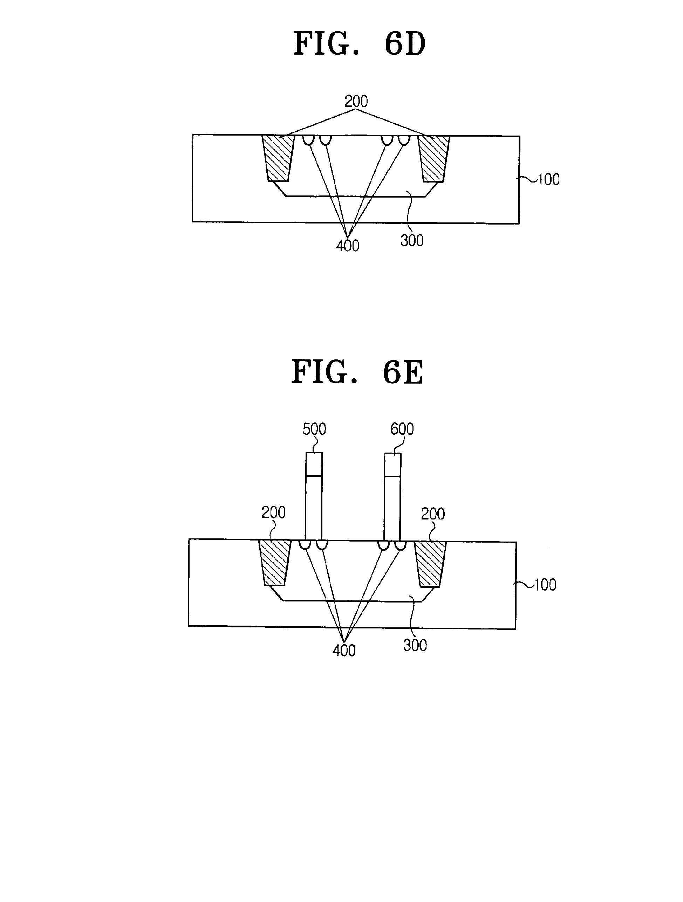

In FIG 6D, the P⁺ type implants 400 are injected to the regions of the N-well layer 300 where the first and second metals 500 and 600 are formed, and heat-treatment is carried out. Here, the P⁺ type implants 400 serve as guarding for preventing currents from flowing from the second metal 600 to the N-well layer 300 when the currents flow from the first metal 500 to the N-well layer 300, or for preventing currents from flowing from the first metal 500 to the N-well layer 300 when the currents flow from the second metal 600 to the N-well layer 300. That is, when currents flow in one direction due to the schottky contact of the metals and the semiconductor substance, the P⁺ type implants 400 prevent the currents from flowing in the reverse direction. Further, the P⁺ type implants 400 are formed on both sides of the first and second metals 500 and 600, respectively, in the schottky contact with the N-well layer 300.

In FIG 6E, the first and second metals 500 and 600 are formed in the schottky contact on the P⁺ type implants 400. Here, the first and second metals 500 and 600 correspond to the positive electrodes.

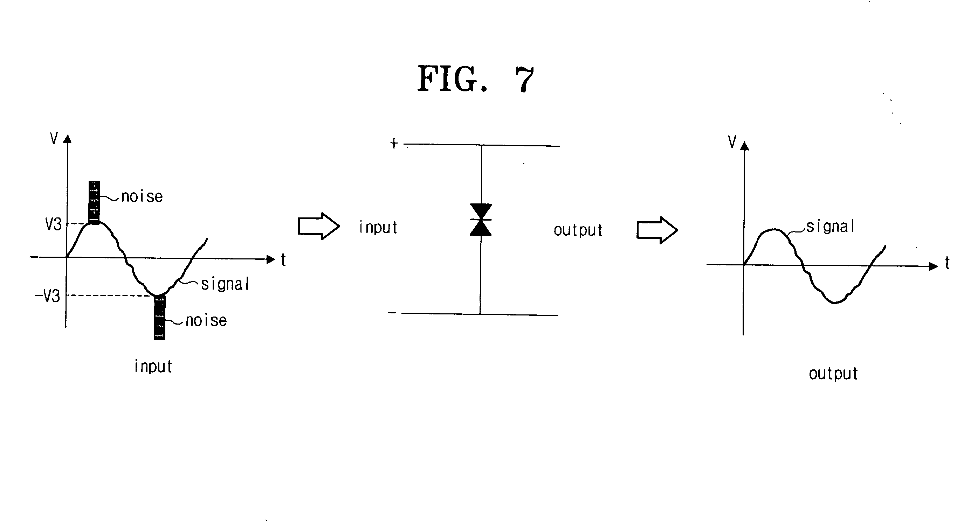

FIG 7 is a view explaining noise removal operations by the semiconductor device of FIG 4.

In FIG 7 and FIG 5, if an analog signal having noise shown in FIG 7 is inputted to the schottky diode according to an exemplary embodiment of the present invention, the noise can be removed. If the noise signal of the signal input to the schottky diode is higher than the voltage V3 and lower than the voltage -V3, the breakdown voltage is adjusted to the voltage V3 along the voltages-to-currents characteristics curve of the schottky diode shown in FIG 5, so the noise of the input signal can be removed.

If a signal of a voltage higher than the voltage V3 is input to the schottky diode in FIG 5, the schottky diode is short-circuited, so the noise signal of the voltage higher than the voltage V3 is not output to the circuit system connected to the schottky diode. Further, if a signal of a voltage higher than |-V3| is input to the schottky diode, the schottky diode is short-circuited, so a noise signal of a voltage higher than |-V3| flows to the ground. Thus, there does not occur a problem of loss of an input signal when the schottky diode is used to remove noise, since different positive and negative voltages cause the schottky diode to become short-circuited.

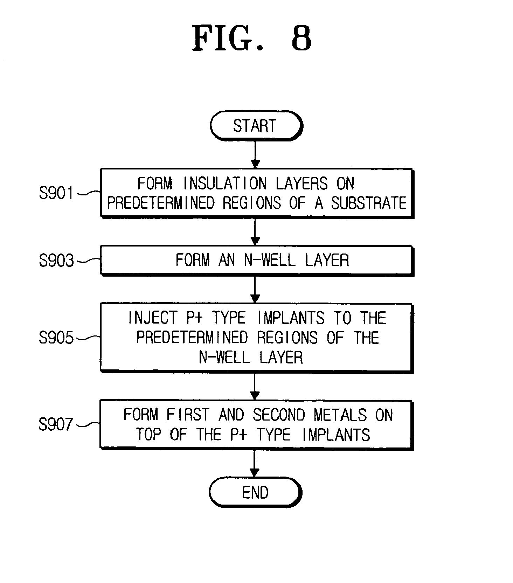

FIG 8 is a flow chart explaining a method for fabricating a semiconductor device for removing noise by using the schottky diode according to an exemplary embodiment of the present invention.

In FIG 8, the insulation layers 200 are formed in an interval on regions of the P-type substrate 100 (S901). The insulation layers 200 can be formed by etching away the regions of the substrate 100 and by forming a nitride oxide layer on the substrate 100.

Next, the N-well layer 300 is formed on a region of the substrate 100 (S903). Here, the N-well layer 300 can be formed by injecting a substance such as As or a material containing As, or other N-well creating material known in the art, between the insulation layers 200 and the substrate 100 and by heat-treating the substrate.

Next, the P⁺ type implants 400 are formed on the regions of the N-well layer 300 (S905). Here, the regions are places on which the first and second metals 500 and 600 are formed, which are formed by injecting the P⁺ type implants to the regions and by heat-treating. Further, the P⁺ type implants are injected on both sides of the regions, respectively, where the first and second metals 500 and 600 are formed. The P⁺ type implants 400 prevent currents from flowing in a reverse direction when the currents flow from the first metal 500 to the N-well layer 300 or from the second metal 600 to the N-well layer 300 with the first and second metals 500 and 600 being in the schottky contact with the N-well layer 300, respectively.

Next, the first and second metals 500 and 600 are formed in the schottky contact on the P⁺ type implants 400 (S907). Here, the first and second metals 500 and 600 correspond to the positive electrodes.

Further, the diode with the schottky diodes connected in series can be used as an ESD device to remove static electricity flowing to a circuit system, and can be applied to diverse circuit systems requiring signal noise removal.

As aforementioned, according to an exemplary embodiment of the present invention, the semiconductor device formed by connecting the same electrodes of the schottky diodes can be used to rectify a noise-bearing digital signal as well as a noise-bearing analog signal.

The foregoing embodiments and advantages are merely exemplary and are not to be construed as limiting the present invention. The present teaching can be readily applied to other types of apparatuses. Also, the description of the exemplary embodiments of the present invention is intended to be illustrative, and not to limit the scope of the claims, and many altematives, modifications, and variations will be apparent to those skilled in the art.

## Claims

1. A semiconductor device fabrication method, comprising:
etching away regions of a P-well substrate and depositing an insulation substance;
etching away the P-well substrate and depositing the insulation substance between the insulation layers to create an N-well layer;
injecting P⁺ type implants to a first region and a second region of the N-well layer; and
forming a first metal in schottky contact on the first region and a second metal in schottky contact on the second region.

2. The semiconductor device fabrication method as claimed in claim 1, wherein the P⁺ type implants are injected to both sides of the region at which the first metal is disposed and to both sides of the region at which the second metal is disposed, and by heat-treating, thereby preventing leakage currents from flowing to the first and second metals.

3. The semiconductor device fabrication method as claimed in claim 1, wherein the regions of the P-well substrate are etched away in a certain interval.

4. The semiconductor device using schottky diodes for removing noise, comprising:
a P-well substrate;
insulation layers which are deposited on etched regions of the P-well substrate;
an N-well layer which is deposited on an etched region of the P-well substrate between the insulation layers;
P⁺ type implants which are injected to a first region and a second region of the N-well layer; and
a first metal formed in schottky contact on the first region and a second metal formed in schottky contact on the second region.

5. The semiconductor device as claimed in claim 4, wherein the P⁺ type implants are injected to both sides of the region at which the first metal is disposed and to both sides of the region at which the second metal is disposed, respectively, and then heat-treated, so that leakage currents are prevented from flowing to the first and second metals.

6. The semiconductor device as claimed in claim 4, wherein the regions of the P-well substrate are etched away in a certain interval.

7. An electrostatic discharge (ESD) prevention device comprising:
a semiconductor device comprising:
a P-well substrate;
insulation layers which are deposited on etched regions of the P-well substrate;
an N-well layer which is deposited on an etched region of the P-well substrate between the insulation layers;
P⁺ type implants which are injected to a first region and a second region of the N-well layer; and
a first metal formed in schottky contact on the first region and a second metal formed in schottky contact on the second region,
wherein static electricity is prevented from flowing to a circuit system connected to the semiconductor device.
